# EUROPÄISCHE PATENTSCHRIFT

(11) **EP 2 338 176 B1**
(45) Veröffentlichungstag und Bekanntmachung des Hinweises auf die Patenterteilung: **08.05.2019**
(21) Anmeldenummer: 09748277.2
(22) Anmeldetag: 19.10.2009
(51) Int. Cl.: F21K 9/00, H05K 1/18, H05K 1/03, H01L 25/075, H05K 1/02, F21V 5/04, H05K 1/11, H05K 3/00, F21Y 115/10, F21Y 107/50

(54) **BELEUCHTUNGSANORDNUNG MIT STUFEN UND EINEM LED-ARRAY**
ILLUMINATION APPARATUS WITH STEPS AND AN LED ARRAY
DISPOSITIF D'ÉCLAIRAGE AVEC DES MARCHES ET UN RÉSEAU DE DIODES ÉLECTROLUMINESCENTES

(30) Priorität: 21.10.2008 DE 102008052427; 12.06.2009 DE 102009025564
(43) Veröffentlichungstag der Anmeldung: 29.06.2011
(73) Patentinhaber: Siemens Aktiengesellschaft, 80333 München (DE)
(72) Erfinder: GERHARD, Detlef, 81829 München (DE)
(86) Internationale Anmeldenummer: PCT/EP2009/063657
(87) Internationale Veröffentlichungsnummer: WO 2010/046339

(56) Entgegenhaltungen:
- EP-A2- 0 921 568
- DE-A1-102008 018 353
- US-A- 3 622 906
- US-A- 5 857 767
- US-A1- 2005 093 146
- US-A1- 2007 080 360
- US-A1- 2008 013 334

## Beschreibung

Die Erfindung betrifft eine Beleuchtungsanordnung mit einem LED-Array, welches aus mindestens zwei LED-Chips besteht, die auf einem Trägerbauteil befestigt sind, welches Leiterbahnen aufweist, mit denen die LED-Chips elektrisch kontaktiert sind.

Eine Beleuchtungsanordnung der eingangs angegebenen Art ist beispielsweise aus der US 2005/0199899 A1 bekannt. Diese Beleuchtungsanordnung weist ein Trägerbauteil in Form einer Leiterplatte auf. Auf diesem sind mehrere LED-Chips angeordnet, die ein Array bilden. Unter Array im Sinne der Erfindung sollen beliebige zweidimensionale Anordnungen von LED-Chips verstanden werden. Insbesondere sind rechteckige Anordnungen von LED-Chips gemeint, welche in Zeilen und Spalten angeordnet sind. Ein LED-Array weist dabei mindestens zwei LED-Chips auf und bildet somit ein 2x1-Array. Die elektrische Kontaktierung der LED-Chips erfolgt über Leiterbahnen, welche derart auf dem Trägerbauteil verlaufen, dass die LED-Chips zur Kontaktierung auf diesen montiert werden können oder eine Kontaktierung beispielsweise über Bonddrähte erfolgen kann. Auf der rückwärtigen Seite des Trägerbauteils kann zudem ein Kühlkörper montiert werden, um die bei dem Betrieb der LED-Chips anfallende Wärme abzuleiten.

Gemäß der US 3,622,906 ist eine Beleuchtungsanordnung mit einem Array von LEDs beschrieben, die auf einem gestuften Substrat auf jeweils benachbarten Stufen angeordnet sind. Die LEDs jeweils benachbarter Stufen werden über Kontaktplättchen miteinander kontaktiert und damit in Reihe geschaltet. Die Kontaktplättchen decken jeweils die Unterseite der LED einer höheren Stufe mit der Oberseite einer LED der nächsttieferen Stufe vollständig ab, so dass eine Abstrahlung von Licht seitwärts erfolgt. Das gestufte Trägerbauteil kann aus einer isolierenden Keramik hergestellt sein und weist zur Kontaktierung der LEDs Metallisierungen auf.

Weiterhin ist gemäß der US 2007/0080360 A1 beschrieben, dass LEDs auf einem Substrat auch mittels Bondverbindungen elektrisch kontaktiert werden können. Auf dem Substrat sind zu diesem Zweck Kontaktflächen neben der LED vorgesehen, auf denen der Bonddraht elektrisch kontaktiert werden kann. Hierbei muss ein genügender Montageraum für das zum Einsatz kommende Bondwerkzeug berücksichtigt werden.

Um eine elektrische Kontaktierung der LED-Chips vornehmen zu können, muss auf dem Trägerbauteil ein genügender Raum vorgesehen werden. Hierdurch entstehen zwangsläufig Zwischenräume zwischen den LED-Chips.

Die Aufgabe der Erfindung liegt darin, eine Beleuchtungsanordnung mit einem LED-Array anzugeben, bei dem die LED-Chips mit vergleichsweise hoher Packungsdichte auf dem Trägerbauteil angebracht werden können und dabei sowohl eine elektrische Kontaktierung möglich ist wie auch eine genügende Ableitung der Verlustwärme erfolgen kann.

Diese Aufgabe wird mit der eingangs genannten Beleuchtungsanordnung erfindungsgemäß dadurch gelöst, dass das Trägerbauteil aus einer elektrisch isolierenden Keramik besteht. Dabei weist die Montageseite des Trägerbauteils für die LED-Chips mehrere gestufte Niveaus auf. Dies soll bedeuten, dass die Oberfläche der Montageseite terrassenartig in mehreren Stufen ausgeführt ist. Jede Stufe bildet ein eigenes Niveau, wobei die Stufenhöhe bevorzugt der Dicke der verwendeten LED-Chips entspricht. Die LED-Chips sind dabei auf mindestens zwei unterschiedlichen Niveaus befestigt. Hierdurch wird vorteilhaft erreicht, dass diese vergleichsweise nahe beieinander liegen können. Die einzelnen Niveaus müssen neben dem Bauraum für die LED-Chips lediglich Flächen zur Kontaktierung derselben zur Verfügung stellen. Durch die gestufte Anordnung der LED-Chips kann jedoch ein Bondwerkzeug zum Anbringen eines Bonddrahtes an die betreffenden Kontaktflächen herangeführt werden, weil hierbei der LED-Chip der jeweils tieferen Stufe die Handhabungen des Bondwerkzeuges nicht stört.

Die Leiterbahnen sind außerdem als Metallisierung auf der die Oberfläche des Trägerbauteils bildenden Montageseite vorgesehen. Dies bedeutet, dass unabhängig davon, auf welchem Niveau die Leiterbahnen verlaufen, diese auf der Oberfläche des Trägerbauteils verlaufen. Hierbei können diese auch zwischen den Niveaus des Trägerbauteils wechseln, indem die Metallisierung über die durch die Stufen gebildeten Flanken hinweggeführt wird. Damit kann das gesamte Trägerbauteil aus demselben elektrisch isolierenden Material gefertigt werden, wodurch Probleme aufgrund unterschiedlicher Ausdehnungskoeffizienten bei einer thermischen Beanspruchung vorteilhaft vermieden werden.

Gemäß einer vorteilhaften Ausgestaltung der Erfindung ist vorgesehen, dass die Keramik eine Wärmeleitfähigkeit von mehr als 50 W/(mK) aufweist, insbesondere aus AlN mit einer Wärmeleitfähigkeit von 195 W/(mK) besteht. Durch Verwendung von Keramiken, die eine vergleichsweise hohe Wärmeleitfähigkeit aufweisen, wird vorteilhaft sichergestellt, dass eine Wärmeableitung der bei dem Betrieb der LED-Chips entstehenden Verlustwärme gewährleistet ist. Hierdurch können die LED-Chips vorteilhaft auch bei hoher Packungsdichte vor einer thermischen Überbeanspruchung geschützt werden.

Gemäß einer weiteren Ausgestaltung der Erfindung ist vorgesehen, dass das Bauteil aus einem monolithischen Körper besteht, dessen Oberflächenstruktur die Niveaus der Montageseite ausbildet. Mit anderen Worten wird das Trägerbauteil einstückig hergestellt. Dies kann beispielsweise durch spanende Bearbeitungsverfahren unter Ausbildung der gewünschten Oberflächenstruktur erfolgen. Die Oberflächenstruktur wird dabei als gewünschte dreidimensionale Gestalt der Montageseite mit den gewünschten Niveaus als Stufen hergestellt. Ein alternatives Verfahren zum spanenden Bearbeiten der Keramik ist die urformtechnische Herstellung des monolithischen Trägerbauteils. Diese wird als Grünling mit der gewünschten Oberflächenstruktur in einer Form hergestellt und anschließend gesintert. Dieses Herstellungsverfahren ist insbesondere bei größeren Stückzahlen besonders vorteilhaft. Die monolithische Herstellung des Trägerkörpers hat den Vorteil, dass keine Übergänge innerhalb des Bauteils vorhanden sind und dadurch die Wärmeleitung innerhalb des Trägerbauteils ungehindert erfolgen kann.

Weiterhin ist vorgesehen, dass die LED-Chips zumindest gruppenweise elektrisch in Reihe geschaltet sind, wobei jeweils eine gegenseitige Kontaktierung der LED-Chips auf benachbarten Niveaus vorgesehen ist. Hierbei kann vorteilhaft die gestufte Struktur des Trägerbauteils genutzt werden, um eine platzsparende Kontaktierung der LED-Chips untereinander vorzunehmen. Wie bereits beschrieben stört jeweils der benachbarte LED-Chip des darunter liegenden Niveaus nicht die Kontaktierung beispielsweise mit Bonddrähten. Der Bonddraht ist dann jeweils auf der abstrahlenden Seite des LED-Chips und auf einer hierfür vorgesehenen Kontaktfläche des nächst höheren Niveaus befestigt. Die Kontaktfläche des nächst höheren Niveaus bildet gleichzeitig die Montagefläche für den auf diesem Niveau befestigten LED-Chip, wobei durch die Montage gleichzeitig die elektrische Kontaktierung zustande kommt. Die LED-Chips können auf den benachbarten Niveaus untereinander durch Bonddrähte miteinander verbunden werden.

Gemäß einer anderen Ausgestaltung der Erfindung ist vorgesehen, dass die Leiterbahnen zu an einem Rand des Trägerbauteils befindlichen Anschlusskontakten zur externen Kontaktierung der Beleuchtungsanordnung geführt sind. Hierdurch wird vorteilhaft die externe Kontaktierung der LED-Chips erleichtert. Gleichzeitig werden im Bereich der Abstrahlfläche der LED-Chips keine Kontaktflächen zur externen Kontaktierung vorgesehen, so dass vorteilhaft hier die optimale Packungsdichte erreicht werden kann. Mit einer externen Kontaktierung ist eine elektrische Spannungsversorgung gemeint, die an das Trägerbauteil angeschlossen ist, um eine elektrische Versorgung der LED-Chips sicherzustellen. Insbesondere, wenn die LED-Chips zu Gruppen (als Serienschaltung) zusammengefasst sind, müssen jeweils nur der erste bzw. letzte LED-Chip einer Gruppe mit einer Leitungszuführung bzw. mit einer Leitungsabführung versehen werden. Dies hat den Vorteil, dass insgesamt weniger externe Anschlüsse notwendig sind.

Weiterhin kann vorteilhaft vorgesehen werden, dass die Anschlusskontakte alle auf demselben Niveau liegen. Dies vereinfacht vorteilhaft den elektrischen Anschluss der externen Energieversorgung, der dann beispielsweise über standardisierte Stecker erfolgen kann, welche passend zu der gefertigten Struktur des Trägerbauteils im Bereich der externen Kontakte ausgewählt werden. Um alle Anschlusskontakte auf demselben Niveau vorsehen zu können, müssen die Leiterbahnen über die durch die einzelnen Niveaus gebildeten Stufen hinweggeführt werden. Hierbei muss die Metallisierung über die durch die Stufen gebildeten Kanten hinweggeführt werden. Besonders vorteilhaft ist es, wenn diese Kanten weniger scharf ausgebildet sind, indem die Leiterbahnen über Rampen zwischen benachbarten Niveaus geführt werden. Dies vereinfacht zum einen die Metallisierung der Oberfläche des Trägerbauteils, zum anderen entstehen vorteilhaft weiniger störanfällige elektrische Verbindungen.

Eine andere Möglichkeit, um leicht zugängliche Anschlusskontakte zu erhalten, besteht darin, dass die externen Anschlusskontakte aus Vias gebildet werden, die eine externe Kontaktierung der Beleuchtungsanordnung auf der der Montageseite abgewandten Rückseite des Trägerbauteils ermöglichen. Dies hat den Vorteil, dass die Leiterbahnen nicht auf ein bestimmtes Niveau geführt werden müssen. Egal, auf welchem Niveau die Leiterbahnen enden, werden diese über die Vias auf die Rückseite des Trägerbauteils zurückgeführt. Diese kann vorteilhaft eben ausgeführt sein, da hier keine gestuften LED untergebracht sind. Außerdem hat diese Anordnung den Vorteil, dass die Bauform des Trägerbauteils kompakter ausgeführt werden kann. Kontaktbereiche auf der Montageseite des Trägerbauteils für die LED-Chips können hierbei nämlich entfallen.

Besonders vorteilhaft ist es, wenn das unterste Niveau für alle in Serie geschalteten Gruppen von LED-Chips eine einzige gemeinsame Leiterbahn zur Verfügung stellt. Die einzelnen Gruppen von LED-Chips werden sozusagen auf Masse gelegt. Hierbei wird sowohl Fertigungs- wie auch Kontaktierungsaufwand eingespart. Die zum Einsatz kommende gemeinsame Leiterbahn muss allerdings hinsichtlich des zur Verfügung stehenden Leitungsquerschnitts so dimensioniert sein, dass der Gesamtstrom aller LED-Chips gleichzeitig ab- bzw. zugeführt werden kann. Vorteilhaft können auf dieser gemeinsamen Leiterbahn auch der jeweils erste LED-Chip der jeweiligen Gruppen von LED-Chips befestigt werden. Hiermit stellt die gemeinsame Leiterbahn gleichzeitig eine vergleichsweise leicht herzustellende Montagefläche für die betreffenden LED-Chips zur Verfügung, was vorteilhaft den Fertigungsaufwand verringert.

Weiterhin ist es vorteilhaft, wenn jeweils eine Leiterbahn für jede Gruppe von LED-Chips auf dem obersten Niveau ausgebildet ist. Das oberste Niveau ist für eine Strukturierung der Metallisierung auf der Oberfläche vorteilhaft besonders leicht zugänglich. Daher kann in diesem Bereich des Trägerbauteils vorteilhaft auf einfache Weise eine Vielzahl von Leiterbahnen hergestellt werden, die dann jeweils mit dem letzten LED-Chip der jeweiligen Gruppe elektrisch verbunden werden können. Auf diese Weise lässt sich jede Gruppe von LED-Chips einzeln ansteuern, was besonders vorteilhaft ist, wenn die Beleuchtungsanordnung LED-Chips verwendet, die unterschiedliche Abstrahlungswellenlängen aufweisen.

Außerdem ist es vorteilhaft, wenn an der der Montageseite abgewandten Rückseite des Trägerbauteils ein Kühlkörper befestigt ist. Dies hat den Vorteil, dass die Wärme, die von den LED-Chips in das Trägerbauteil eingeleitet wird, in den Kühlkörper abgeführt werden kann. Daher ist die Kühlung der LED-Chips nicht allein von der Wärmekapazität des Trägerbauteils abhängig. Der Kühlkörper kann beispielsweise aus einem Material mit hoher Wärmekapazität, wie z. B. Kupfer, gefertigt sein. Hierdurch entsteht ein Kühlkörper zur passiven Kühlung. Alternativ ist auch eine aktive Kühlung denkbar. Hierbei könnte ein Kühlkörper angeordnet werden, der durch ein Kühlmedium, wie z. B. eine Kühlflüssigkeit, durchflossen ist. Eine aktive Kühlung kann vorteilhaft abhängig von der LED-Leistung geregelt werden.

Außerdem ist es vorteilhaft, wenn auf der Montageseite des Trägerbauteils eine Aufnahme für ein optisches Element vorgesehen ist. Optische Elemente können beispielsweise Linsenelemente oder auch optische Filter sein.

Weitere Einzelheiten der Erfindung werden nachfolgend anhand der Zeichnung beschrieben. Gleiche oder sich entsprechende Zeichnungselemente sind jeweils mit dem gleichen Bezugszeichen versehen und werden nur insoweit mehrfach erläutert, wie sich Unterschiede zwischen den einzelnen Figuren ergeben. Es zeigen
- Figur 1: ein Ausführungsbeispiel des erfindungsgemäßen Trägerbauteils in einer räumlichen Ansicht,
- Figur 2: den Schnitt durch ein anderes Ausführungsbeispiel des erfindungsgemäßen Bauteils, auf dem LED-Chips montiert sind und
- Figur 3: ein Ausführungsbeispiel des erfindungsgemäßen Bauteils als Ausschnitt, in der der Verlauf der Leiterbahnen zu erkennen ist.

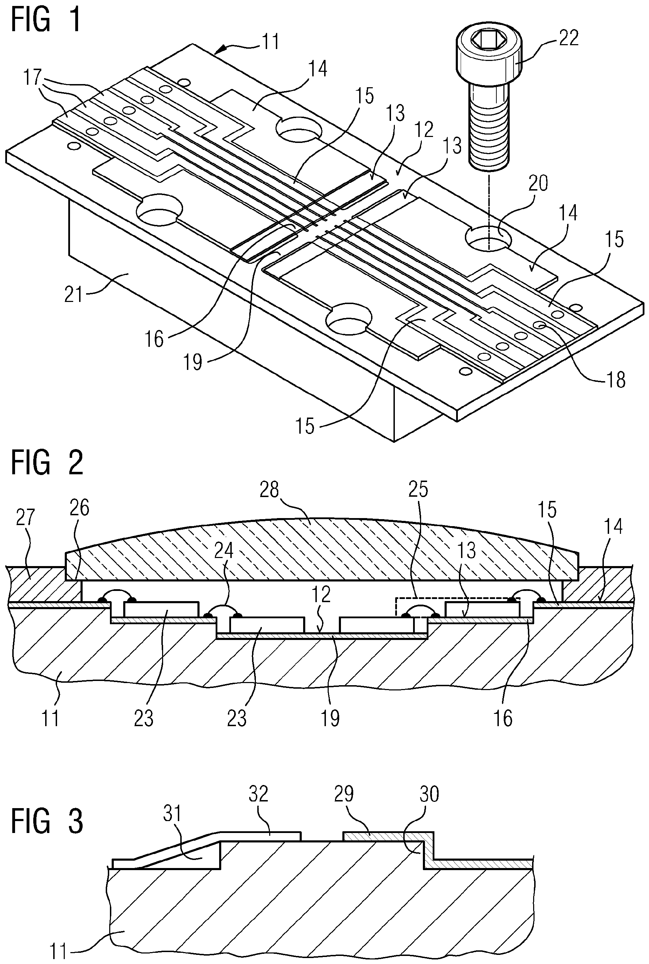

In Figur 1 ist ein Trägerbauteil 11 dargestellt, welches aus einem monolithischen Keramikblock aus AlN hergestellt ist. hierbei handelt es sich um eine HTC-Keramik. Die in Figur 1 dargestellte Oberseite des Trägerbauteils bildet eine Montageseite für nicht dargestellte LED-Chips, wobei die Oberfläche der Montageseite stufenförmig ausgeführt ist und ein unteres Niveau 12, ein mittleres Niveau 13 und ein oberes Niveau 14 aufweist. Auf dem unteren und dem mittleren Niveau können in nicht dargestellter Weise die LED-Chips montiert werden (vgl. hierzu Figur 2). Um die montierten LED-Chips extern kontaktieren zu können, ist eine strukturierte Metallisierung auf der Montageseite des Trägerbauteils vorgesehen. Zu erkennen sind z. B. Leiterbahnen 15 auf dem obersten Niveau, die an mehrere auf Kontaktflächen 16 des mittleren Niveaus 13 montierbare LED-Chips herangeführt werden. Außerdem können die Leiterbahnen am Rand des Trägerbauteils 11 als Anschlusskontakte 17 für eine externe elektrische Kontaktierung dienen. Alternativ kann eine Kontaktierung auch auf der Rückseite des Trägerbauteils 11 vorgenommen werden, da diese Rückseite über Vias 18 mit den Leiterbahnen 15 verbunden ist.

Auf dem unteren Niveau 12 des Trägerbauteils 11 ist eine einzige Leiterbahn 19 vorgesehen, die zur Aufnahme aller auf diesem Niveau zu montierenden LED-Chips (vgl. Figur 2) dient. Auch diese wird an den Rand des Trägerbauteils herangeführt und mittels eines Vias elektrisch mit der Rückseite des Trägerbauteils 11 verbunden.

Weiterhin ist zu erkennen, dass das Trägerbauteil Bohrungen 20 aufweist, welche für die Befestigung eines Kühlkörpers 21 vorgesehen sind. die Befestigung des Kühlkörpers kann beispielsweise mittels Schrauben 22 erfolgen.

Der Figur 2 lässt sich entnehmen, wie LED-Chips 23 auf dem Trägerbauteil 11 befestigt werden können. Auf der unteren Ebene 12, die, wie in Figur 1 dargestellt, eine einzige Leiterbahn 19 aufweist, sind die LED-Chips 23 elektrisch leitend montiert, so dass diese jeweils die ersten oder letzten (je nach Betrachtungsweise) der Gruppen von in Reihe geschalteten LED-Chips bilden. Auf dem mittleren Niveau sind auf den Kontaktflächen 16 weitere LED-Chips elektrisch leitend montiert, wobei die Reihenschaltung zu den jeweils auf dem unteren Niveau befindlichen LED-Chips über Bonddrähte 24 erfolgt. Eine gestrichelt angedeutete Alternative, dass LED-Chips mit größeren Abmessungen 25 verwendet werden können, die sich nach der Montage auf einzelnen Niveaus überlappen würden, wodurch eine Kontaktierung zwischen den LED-Chips beispielsweise durch einen Lotwerkstoff direkt erfolgen könnte, ist nicht verwirklicht. Die Leiterbahnen 15 auf dem oberen Niveau 14 des Trägerbauteils 11 dienen lediglich der Kontaktierung der LED-Chips auf dem mittleren Niveau 16 mittels Bonddrähten 24. Damit bilden in dem. Ausführungsbeispiel gemäß Figur 2 die LED-Chips auf dem mittleren Niveau die jeweils letzten (oder ersten - je nach Betrachtungsweise) LED-Chips in der jeweiligen Gruppe von in Serie geschalteten LED-Chips. Selbstverständlich kann anders als in dem Ausführungsbeispiel gemäß Figur 2 durch Vorsehen mehrerer mittlerer Niveaus auch eine Serienschaltung von mehr als zwei LED-Chips pro Gruppe erfolgen (nicht dargestellt).

Weiterhin ist auf dem Trägerbauteil 11 gemäß Figur 2 ein über dem oberen Niveau 14 liegendes weiteres Niveau 26 vorgesehen, welches eine Aufnahme 27 für ein optisches Element in Form einer Linse 28 bildet. Die Linse überspannt die Gesamtheit der verwendeten LED-Chips 23 und kann beispielsweise der Bündelung des von den LED-Chips 23 abgestrahlten Lichtes dienen.

In Figur 3 sind beliebige Niveaus des Trägerbauteils 11 schematisch dargestellt. Eine Leiterbahn 29 ist über die durch die Niveaus gebildete Stufe 30 geführt, wobei hierbei zwei Umlenkungen der Leiterbahnen um jeweils 90° entstehen. Dies kann fertigungstechnisch zu Problemen führen, weswegen als Übergang zwischen den Niveaus auch eine Rampe 31 vorgesehen werden kann, über die die hinter der Zeichenebene dargestellte Leiterbahn 32 geführt werden kann. Hierbei entstehen weniger scharfe Umlenkungen der Leiterbahn 32, wodurch die fertigungstechnischen Probleme verhindert werden können.

## Patentansprüche

1. Beleuchtungsanordnung mit einem LED-Array, welches aus mindestens zwei LED-Chips (23) besteht, die auf einem Trägerbauteil (11) befestigt sind, welches Leiterbahnen (15) aufweist, mit denen die LED-Chips (23) elektrisch kontaktiert sind, wobei
• das Trägerbauteil (11) aus einer elektrisch isolierenden Keramik besteht,
• die Montageseite des Trägerbauteils (11) für die LED-Chips (23) mehrere gestufte Niveaus (12, 13, 14) aufweist,
• die LED-Chips (23) auf mindestens zwei unterschiedlichen Niveaus (12, 13, 14) befestigt sind,
• die Leiterbahnen (15) als Metallisierung auf der die Oberfläche des Trägerbauteils (11) bildenden Montageseite vorgesehen sind,
• die LED-Chips (23) zumindest gruppenweise elektrisch in Reihe geschaltet sind, wobei jeweils eine gegenseitige Kontaktierung von LED-Chips (23) auf benachbarten Niveaus (12, 13, 14) vorgesehen ist,
**dadurch gekennzeichnet,**
**dass** die jeweilige Kontaktierung der LED-Chips (23) auf benachbarten Niveaus (12, 13, 14) untereinander durch einen Bonddraht (24) ausgebildet ist, wobei der Bonddraht (24) jeweils auf einer abstrahlenden Seite des LED-Chips (23) und auf einer hierfür vorgesehenen Kontaktfläche (16) des nächst höheren Niveaus (12, 13, 14) befestigt ist.

2. Beleuchtungsanordnung nach Anspruch 1,
**dadurch gekennzeichnet,**
**dass** die Keramik eine Wärmeleitfähigkeit von mehr als 50 W/(mK) aufweist, insbesondere aus AlN mit einer Wärmeleitfähigkeit von 195 W/(mK) besteht.

3. Beleuchtungsanordnung nach einem der voranstehenden Ansprüche,
**dadurch gekennzeichnet,**
**dass** das Trägerbauteil (11) aus einem monolithischen Körper besteht, dessen Oberflächenstruktur die Niveaus (12, 13, 14) der Montageseite ausbildet.

4. Beleuchtungsanordnung nach einem der voranstehenden Ansprüche,
**dadurch gekennzeichnet,**
**dass** die Leiterbahnen (15) zu an einem Rand des Trägerbauteils (11) befindlichen Anschlusskontakten (17) zur externen Kontaktierung der Beleuchtungsanordnung geführt sind.

5. Beleuchtungsanordnung nach Anspruch 4,
**dadurch gekennzeichnet,**
**dass** die Anschlusskontakte (17) alle auf demselben Niveau (12, 13, 14) liegen.

6. Beleuchtungsanordnung nach Anspruch 5,
**dadurch gekennzeichnet,**
**dass** die Leiterbahnen (15) über Rampen (31) zwischen benachbarten Niveaus (12, 13, 14) geführt werden.

7. Beleuchtungsanordnung nach Anspruch 4,
**dadurch gekennzeichnet,**
**dass** die externen Anschlusskontakte aus Vias (18) gebildet werden, die eine externe Kontaktierung der Beleuchtungsanordnung auf der der Montageseite abgewandten Rückseite des Trägerbauteils (11) ermöglichen.

8. Beleuchtungsanordnung nach einem der Ansprüche 4 bis 7,
**dadurch gekennzeichnet,**
**dass** das unterste Niveau (12) für alle in Serie geschalteten Gruppen von LED-Chips (23) eine einzige gemeinsame Leiterbahn (19) zur Verfügung stellt.

9. Beleuchtungsanordnung nach einem der Ansprüche 4 bis 8,
**dadurch gekennzeichnet,**
**dass** jeweils eine Leiterbahn (15) für jede Gruppe von LED-Chips (23) auf dem obersten Niveau ausgebildet ist.

10. Beleuchtungsanordnung nach einem der Ansprüche 4 bis 9,
**dadurch gekennzeichnet,**
**dass** der erste LED-Chip (23) der jeweiligen Gruppe auf der zugehörigen Leiterbahn (19) auf dem untersten Niveau (12) befestigt ist.

11. Beleuchtungsanordnung nach einem der Ansprüche 4 bis 10,
**dadurch gekennzeichnet,**
**dass** die Leiterbahnen (15) auf dem obersten Niveau jeweils mit dem letzten LED-Chip (23) der jeweiligen Gruppe elektrisch verbunden sind, wobei dieser LED-Chip (23) jeweils auf dem Niveau (13) unterhalb des obersten Niveaus (14) befestigt ist.

12. Beleuchtungsanordnung nach einem der voranstehenden Ansprüche,
**dadurch gekennzeichnet,**
**dass** an der der Montageseite abgewandten Rückseite des Trägerbauteils (11) ein Kühlkörper (21) befestigt ist.

13. Beleuchtungsanordnung nach einem der voranstehenden Ansprüche,
**dadurch gekennzeichnet,**
**dass** auf der Montageseite des Trägerbauteils (11) eine Aufnahme (27) für ein optisches Element (28) ausgebildet ist.

## Claims

1. Illumination arrangement comprising an LED chip array consisting of at least two LED chips (23) secured on a carrier component (11) having conductor tracks (15) with which the LED chips (23) are electrically contacted, wherein
• the carrier component (11) consists of an electrically insulating ceramic,
• the mounting side of the carrier component (11) for the LED chips (23) has a plurality of stepped levels (12, 13, 14),
• the LED chips (23) are secured on at least two different levels (12, 13, 14),
• the conductor tracks (15) are provided as metallization on the mounting side forming the surface of the carrier component (11),
• the LED chips (23) are electrically connected in series at least in groups, wherein a mutual contacting of LED chips (23) on adjacent levels (12, 13, 14) is respectively provided,
**characterized in that**
respective contacting of the LED chips (23) on adjacent levels (12, 13, 14) among one another is formed by a bond wire (24), wherein the bond wire (24) is respectively secured on an emissive side of the LED chip (23) and on a contact pad (16) of the next higher level (12, 13, 14), said contact pad being provided for this purpose.

2. Illumination arrangement according to Claim 1,
**characterized in that**
the ceramic has a thermal conductivity of more than 50 W/(mK), in particular consists of AlN having a thermal conductivity of 195 W/(mK).

3. Illumination arrangement according to either of the preceding claims,
**characterized in that**
the carrier component (11) consists of monolithic body whose surface structure forms the levels (12, 13, 14) of the mounting side.

4. Illumination arrangement according to any of the preceding claims,
**characterized in that**
the conductor tracks (15) are layered to connection contacts (17) for the external contacting of the illumination arrangement, said connection contacts being situated at an edge of the carrier component (11) .

5. Illumination arrangement according to Claim 4,
**characterized in that**
the connection contacts (17) all lie on the same level (12, 13, 14).

6. Illumination arrangement according to Claim 5,
**characterized in that**
the conductor tracks (15) are led by way of ramps (31) between adjacent levels (12, 13, 14).

7. Illumination arrangement according to Claim 4,
**characterized in that**
the external connection contacts are formed from vias (18) enabling an external contacting of the illumination arrangement on the rear side of the carrier component (11) facing away from the mounting side.

8. Illumination arrangement according to any of Claims 4 to 7,
**characterized in that**
the bottommost level (12) makes available a single common conductor track (19) for all series-connected groups of LED chips (23).

9. Illumination arrangement according to any of Claims 4 to 8,
**characterized in that**
a respective conductor track (15) for each group of LED chips (23) is formed on the topmost level.

10. Illumination arrangement according to any of Claims 4 to 9,
**characterized in that**
the first LED chip (23) of the respective group is secured on the associated conductor track (19) on the bottommost level (12).

11. Illumination arrangement according to any of Claims 4 to 10,
**characterized in that**
the conductor tracks (15) on the topmost level are electrically connected in each case to the last LED chip (23) of the respective group, wherein said LED chip (23) is secured in each case on the level (13) below the topmost level (14).

12. Illumination arrangement according to any of the preceding claims,
**characterized in that**
a heat sink (21) is secured to the rear side of the carrier component (11) facing away from the mounting side.

13. Illumination arrangement according to any of the preceding claims,
**characterized in that**
a receptacle (27) for an optical element (28) is formed on the mounting side of the carrier component (11) .

## Revendications

1. Dispositif d'éclairage, comprenant un réseau de DEL, constitué d'au moins deux puces DEL (23), qui sont fixées sur une pièce (11) de support, laquelle a des pistes (15) conductrices, par lesquelles les puces DEL (23) sont contactées électriquement, dans lequel
• la pièce (11) de support est en une céramique isolante du point de vue électrique,
• le côté de montage de la pièce (11) de support des puces DEL (23) a plusieurs niveaux (12, 13, 14) étagés,
• les puces DEL (23) sont fixées à au moins deux niveaux (12, 13, 14) différents,
• les pistes (15) conductrices sont prévues sous la forme de métallisation sur le côté de montage formant la surface de la pièce (11) de support,
• les puces DEL (23) sont montées au moins par groupe électriquement en série, une mise en contact mutuelle de puces DEL (23) à des niveaux (12, 13, 14) voisins étant prévue,
**caractérisé**
**en ce que** la mise en contact des puces DEL (23), à des niveaux (12, 13, 14) voisins entre elles, est constituée par un fil (24) de liaison, le fil (24) de liaison étant fixé respectivement sur un côté rayonnant de la puce DEL (23) et sur une surface (16) de contact prévue à cet effet du niveau (12, 13, 14) immédiatement plus haut.

2. Dispositif d'éclairage suivant la revendication 1,
**caractérisé**
**en ce que** la céramique a une conductivité thermique de plus de 50 W/(mK), en étant notamment en AlN ayant une conductivité thermique de 195 W/(mK).

3. Dispositif d'éclairage suivant l'une des revendications précédentes,
**caractérisé**
**en ce que** la pièce (11) de support est constituée d'un corps monolithique, dont la structure de surface forme les niveaux (12, 13, 14) du côté de montage.

4. Dispositif d'éclairage suivant l'une des revendications précédentes,
**caractérisé**
**en ce que** les pistes (15) conductrices vont, pour la mise en contact avec l'extérieur de l'agencement d'éclairage, à des contacts (17) de connexion se trouvant sur un bord de la pièce (11) de support.

5. Dispositif d'éclairage suivant la revendication 4,
**caractérisé**
**en ce que** les contacts (17) de connexion sont tous au même niveau (12, 13, 14).

6. Dispositif d'éclairage suivant la revendication 5,
**caractérisé**
**en ce que** les pistes (15) conductrices passent sur des rampes (31) entre des niveaux (12, 13, 14) voisins.

7. Dispositif d'éclairage suivant la revendication 4,
**caractérisé**
**en ce que** les contacts de connexion avec l'extérieur sont formés de traversées (18) qui rendent possible une mise en contact avec l'extérieur du dispositif d'éclairage du côté arrière de la pièce (11) de support, loin du côté de montage.

8. Dispositif d'éclairage suivant l'une des revendications 4 à 7,
**caractérisé**
**en ce que** le niveau (12) le plus bas met à disposition de tous les groupes de puces DEL (13) montés en série, une piste (19) conductrice commune unique.

9. Dispositif d'éclairage suivant l'une des revendications 4 à 8,
**caractérisé**
**en ce que** respectivement une piste (15) conductrice, pour chaque groupe de puces DEL (23), est constituée au niveau le plus haut.

10. Dispositif d'éclairage suivant l'une des revendications 4 à 9,
**caractérisé**
**en ce que** la première puce DEL (23) d'un groupe est fixée sur la piste (19) conductrice associée au niveau (12) le plus bas.

11. Dispositif d'éclairage suivant l'une des revendications 4 à 10,
**caractérisé**
**en ce que** les pistes (15) conductrices, au niveau le plus haut, sont reliées, respectivement, du point de vue électrique à la dernière puce DEL (23) du groupe, cette puce DEL (23) étant fixée, respectivement, au niveau (13) en dessous du niveau (14) le plus haut.

12. Dispositif d'éclairage suivant l'une des revendications précédentes,
**caractérisé**
**en ce qu'**un puits de chaleur (11) est fixé du côté arrière de la pièce (11) de support, loin du côté de montage.

13. Dispositif d'éclairage suivant l'une des revendications précédentes,
**caractérisé**
**en ce qu'**un logement (27) d'un élément (28) optique est constitué du côté de montage de la pièce (11) de support.
